# EUROPEAN PATENT APPLICATION

(11) **EP 0 533 375 A2**
(43) Date of publication of application: **24.03.1993**
(21) Application number: 92307966.9
(22) Date of filing: 02.09.1992
(51) Int. Cl.: G11C 29/00

(54) **Computer system having memory testing means**

(30) Priority: 18.09.1991 US 761533
(71) Applicant: NCR International, Inc., Dayton, Ohio 45479 (US)
(72) Inventor: Kass, William J., Easley, SC 29642 (US); Hawkey, Jeffrey A., Easley, SC 29640 (US)
(74) Representative: Robinson, Robert George

(57) **Abstract**

In apparatus for testing memory in a computer, without involvement of the processors which are used by the computer to run its programs, the testing is done by a testing circuit which multiplexes into the data and address buses leading to memory. When operative, the testing circuit first writes a test word to all memory addresses. Then the testing circuit reads each address, and checks for accuracy. If an error is found, the address of the error is stored. In a computer with multiple memory boards, a separate testing can proceed substantially simultaneously (and asynchronously), thereby enabling the testing procedure to be completed rapidly.

## Description

This invention relate to computer systems of the kind including main processing means and memory means.

Personal computers and microcomputers are currently manufactured with increasingly large amounts of random access memory (RAM). With the utilization of large amounts of RAM there arises an increased probability of errors arising from RAM malfunctions.

It is an object of the present invention to provide a computer system including main processing means and memory means wherein memory error checking can be carried out in an efficient manner.

Therefore, according to the present invention, there is provided a computer system including main processing means coupled to memory means, characterized by memory testing means operable independently of said main processing means and adapted to test said memory means in response to a signal from said processing means.

One embodiment of the present invention will now be described by way of example, with reference to the accompanying drawings, in which:
Figure 1 illustrated three memory boards in a computer;
Figures 2A and 2B are an enlargement of dashed blocks 3 in Figure 1.
Figure 3 illustrates the operation of the components of dashed blocks 3; and
Figures 4 and 5 are schematics which show the components making up the equipment in dashed block 3.

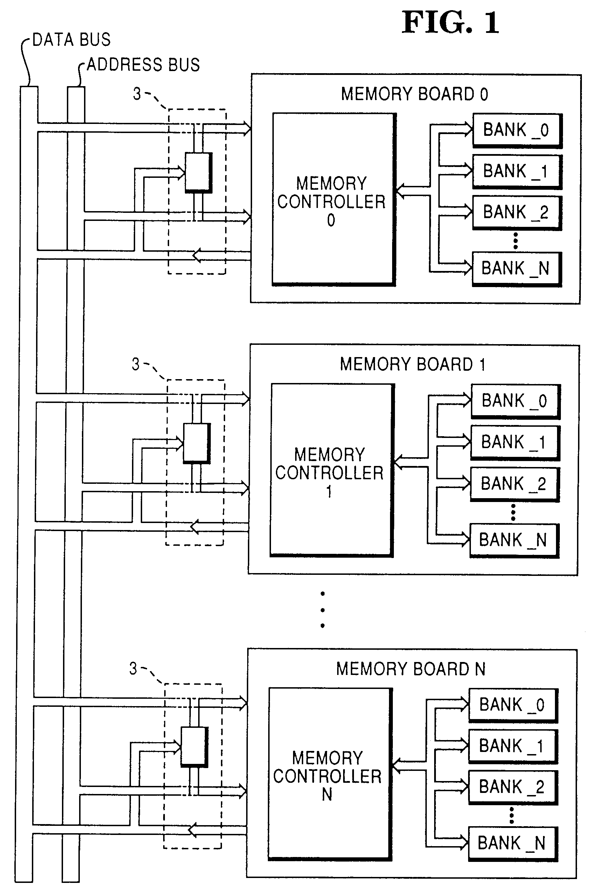

Figure 1 illustrates several memory boards in a computer, each connected to both a data bus and an address bus. A "memory board" is a printed circuit board which contains one or more banks of memory, together with a memory controller. Boards, banks, and controllers are known in the art.

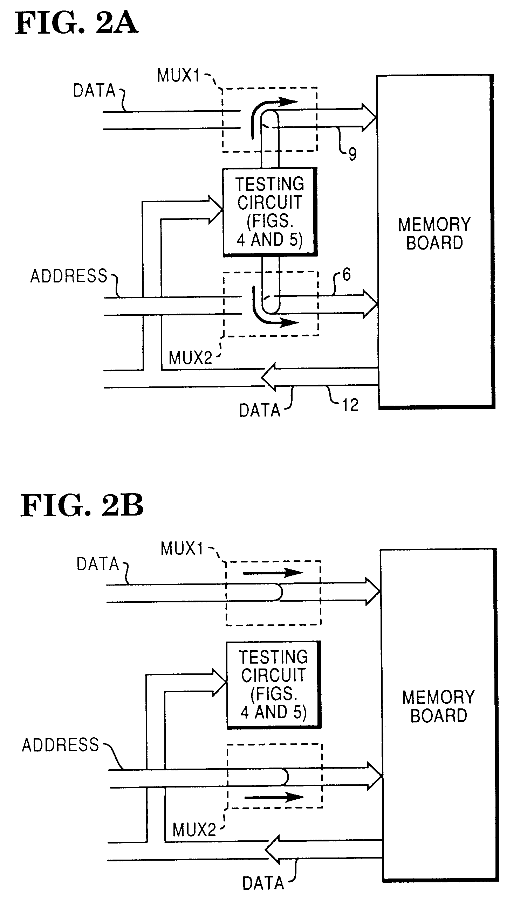

Figures 2A and 2B show an enlarged view of one block 3. Each block contains a testing circuit which can be interconnected into the data- and address busses by multiplexers MUX1 and MUX2. That is, when testing is in operation, the multiplexers make the connections shown in Figure 2A. When testing is not in operation, the connections are those of Figure 2B and the computer system operates normally.

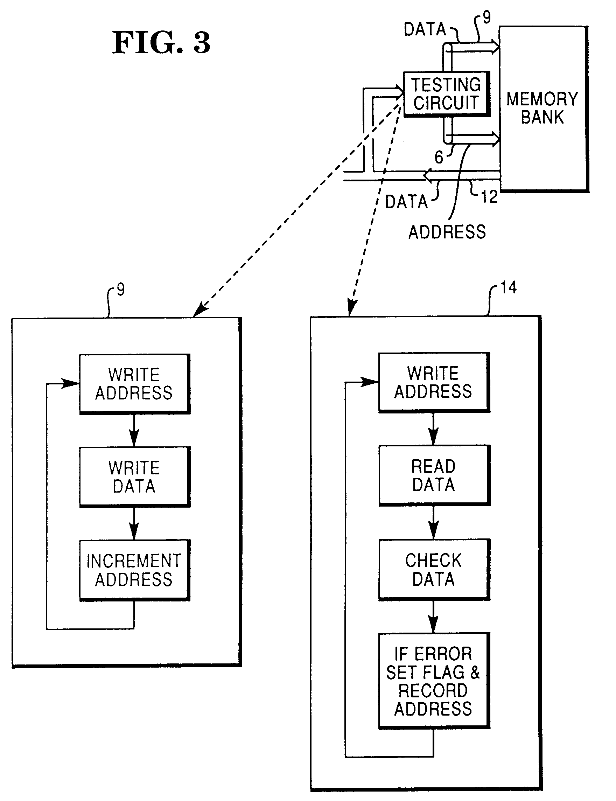

As indicated in Figure 3, the testing circuit performs the following two sequence of events:

### First Sequence (Block 9, Figure 3)

1. The testing circuit writes, onto bus 6, the lowest address on the memory board.
2. The testing circuit writes, onto bus 9, a known data word. The data word is thus written to the address of step 1.
3. The testing circuit increments the address and repeats the sequence, beginning with step 1.

After the data word has been written to all memory locations in the bank, the testing circuit proceeds to the Second Sequence:

### Second Sequence (Block 14, Figure 3)

4. The testing circuit writes, onto bus 6, the lowest address on the memory board.
5. The testing circuit reads the data at the address just written written in step 4. The data is read on bus 12.
6. The testing circuit checks the data just read against the original which was written in the First Sequence. If there is a discrepancy, the testing circuit sets an error flag and records the address from which the data was read.
7. The testing circuit increments the address, and repeats the sequence, beginning with step 4.

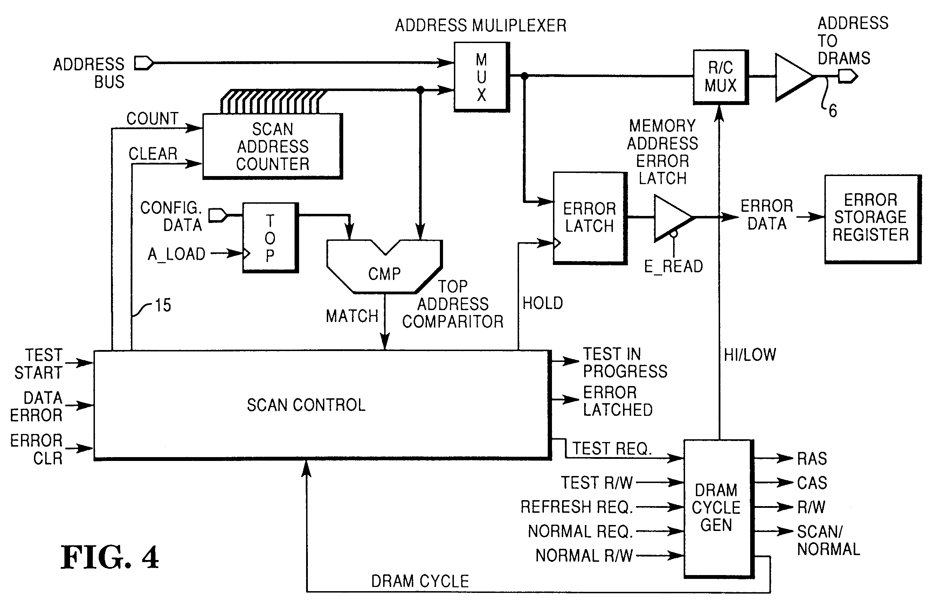

After all of the addresses on the board have been read and checked, the testing circuit issues a signal on the TEST IN PROGRESS line in Figure 4 (later discussed). This signal indicates to the processor that the test is complete, and allows the processor to gain access, if desired, to the data recorded in step 6, regarding the faults.

This approach tests several boards simultaneously, rather than in sequence, thus saving time. Further, the central processor (or group of processors) is uninvolved in the testing procedure, except to initiate the test and read the results.

The preceding explanation is a simplification. The invention will now be discussed in more detail.

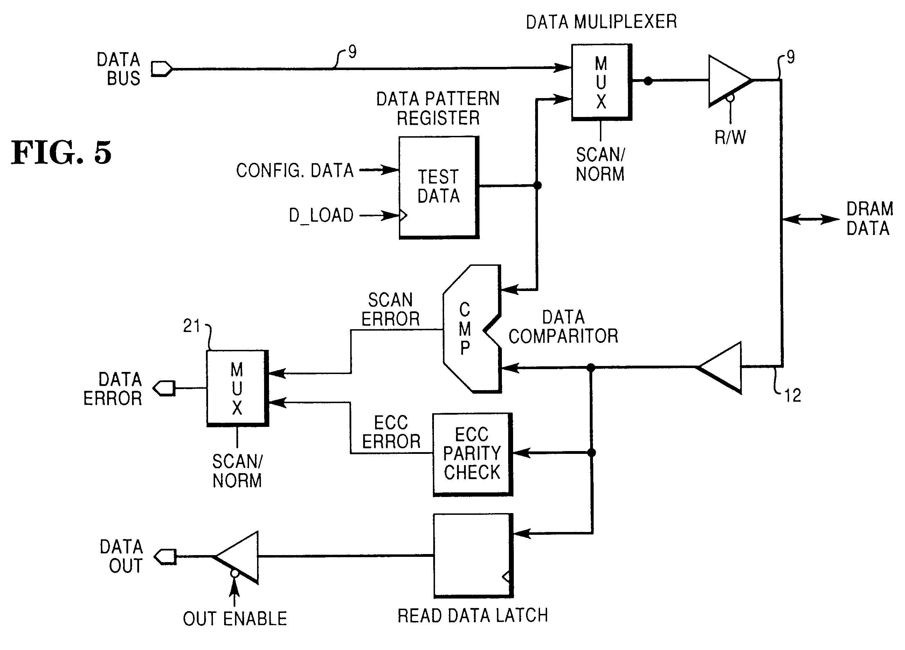

Figures 4 and 5 illustrate the dashed blocks 3 in more detail. The components of these Figures will be explained in two stages, namely, an overview and a detailed discussion.

A SCAN CONTROL circuit in Figure 4 orders a SCAN ADDRESS COUNTER into action. The SCAN ADDRESS COUNTER delivers a sequence of addresses to the ADDRESS MULTIPLEXER (which corresponds to MUX2 in Figure 2), which passes the sequence to bus 6 in Figure 4. Meanwhile, each address is compared, in a TOP ADDRESS COMPARATOR, with a ceiling address contained in register TOP. When the two addresses are equal, the ceiling address in the board has been reached and the address incrementation stops.

After the address has settled on bus 6, a DATA MULTIPLEXER in Figure 5 (which corresponds to MUX1 in Figure 2) takes a data pattern, or data word, from the DATA PATTERN REGISTER and delivers the pattern to bus 9. The data pattern is then written to the address on bus 6, under command of signals generated by the DRAM CYCLE GENERATOR in Figure 4, which are sent to the memory controller, which is shown in Figure 1.

After all addresses in the board have been written with the data pattern, the addressing starts over again, but for reading. During each read operation, the DATA COMPARATOR in Figure 5 compares the data at each address with the DATA PATTERN contained in the register TEST DATA. If there is a discrepancy, the DATA COMPARATOR issues a SCAN ERROR signal. In addition, another type of error check is done, namely, a check of the parity of the error correction code. This check is done by the block ECC PARITY CHECK. If there is a discrepancy, an ECC ERROR signal is produced. Multiplexer MUX 21 delivers the errors to the SCAN CONTROL circuit in Figure 4.

In response to errors, the SCAN CONTROL circuit directs, by way of a HOLD signal, that the address contained in register ERROR LATCH be stored in an ERROR STORAGE REGISTER. This storage operation records the address of the present faulty memory location.

In more detail, the operation is as follows.

SCAN ADDRESS COUNTER (Figure 4). A signal on line 15 actuates the COUNTER, causing it to reset to zero. Then, each COUNT signal increments the COUNTER by one.

TOP ADDRESS COMPARATOR (Figure 4). A register TOP contains a number which indicates the highest address in the board. This number is provided either by the processor, by DIP switches on the memory board, or by other suitable apparatus. The COMPARATOR compares the address produced by the SCAN ADDRESS COUNTER with the address in register TOP. When they become equal, a MATCH signal is produced, indicating that the address applied on bus 6 in Figure 3 now equals the address in register TOP. Thus, at this time, all addresses on the board have been covered.

ADDRESS MULTIPLEXER (Figure 4. Also indicated as MUX2 in Figure 2). This MULTIPLEXER selects one of two available addresses, and sends it to the memory, via bus 6 in Figure 3. The available addresses are (1) that on the ADDRESS BUS in Figures 1 and 4 (which is the system address bus) and (2) that provided by the SCAN ADDRESS COUNTER. During the memory test, the latter address is selected. During normal computer operation, the former is selected.

MEMORY ADDRESS ERROR LATCH (Figure 4). This latch is a register which holds the address currently being applied (on bus 6 in Figure 2) to memory. If an error at the memory address is detected (as later described), the address contained in this LATCH is maintained and not overwritten any further, until the error flag is cleared.

DATA PATTERN REGISTER (Figure 5). This REGISTER contains the data pattern, or data word, to be used. This pattern is written to each memory location. The particular pattern used is loaded by a processor into the DATA PATTERN REGISTER. The pattern can, of course, be changed.

DATA COMPARATOR (Figure 5). This COMPARATOR compares the data previously written (on bus 9 in Figure 2) to the memory address (on bus 6 in Figure 2) with the original data pattern, which is held in the DATA PATTERN REGISTER. If there is a discrepancy, a SCAN ERROR signal is generated.

DATA MULTIPLEXER (Figure 5, also indicated as MUX1 in Figure 2). This MULTIPLEXER selects one of two available data words, and sends it to the memory. The available words are (1) that on the DATA BUS and (2) that provided by the DATA PATTERN REGISTER. During the memory test, the latter data is selected. During normal computer operation, the former is selected.

SCAN CONTROL (Figure 4). This performs the following operations.
**One**, it receives a TEST START signal from a processor and initiates the testing sequence, by issuing the proper signal to the SCAN ADDRESS COUNTER. Also, it switches MUX1 and MUX 2 into the states shown in Figure 2A.
**Two**, it issues the proper sequence of enabling signals (RAS, CAS, R/W, etc) to its associated memory controller in Figure 1 and to the DRAM CYCLE GENERATOR (Figure 4). These signals direct the memory controller to accept the address on bus 6 in Figure 2A, to write the DATA PATTERN (on bus 9) to that address, and to read the data written. **Three**, it captures the DATA ERROR signals, produced by MUX 21 in Figure 5, and, in response, orders the ERROR LATCH in Figure 4 to store the address.
Designing an apparatus to perform these functions is known to those skilled in the art.

Therefore, once the processor (or other controller) issues a TEST START signal, as indicated in Figure 4, the SCAN CONTROL circuit handles the rest of the testing. Accordingly, the processor is thereafter uninvolved in the testing procedure.

In the described embodiment it was presumed that the TEST START signals issued to the blocks 3 in Figure 1 were issued in sequence. Thus, each TESTING CIRCUIT in Figure 3 begins at a different time and, in general, will run independently and asynchronously of each other. However, in a modification, it is possible to trigger all the blocks 3 simultaneously.

## Claims

1. A computer system including main processing means coupled to memory means, characterized by memory testing means (3) operable independently of said means processing means and adapted to test said memory means in response to a signal from said processing means.

2. A computer system according to claim 1, characterized in that said main processing means is coupled to said memory means by data bus means and address bus means, and in that said memory testing means (3) includes multiplexing means (MUX1, MUX2), coupled to said data bus means, said address bus means and to test control means.

3. A computer system according to claim 2, characterized in that said memory means includes a plurality of memory units coupled to said data bus and said address bus, and in that said test control means includes a plurality of individual testing circuits adapted to test said memory units, respectively.

4. A computer system according to claim 3, characterized in that said testing circuits operate asynchronously.

5. A computer system according to claim 3 or claim 4, characterized in that each testing circuit is adapted to write a data word to each address in the associated memory unit and read out the written words, said testing circuit including comparison means adapted to compare the read out words with the written word and to generate an error signal if a difference is detected.

6. A computer system according to claim 5, characterized in that each testing circuit includes: a counter adapted to provide an incrementing sequence of addresses, an address multiplexer adapted to selectively apply to the associated memory unit either an address from said address bus or said incrementing sequence of addresses; a register adapted to hold a data pattern; and a data multiplexer adapted to selectively apply to the associated memory unit either data from said data bus or said data pattern, said comparison means being adapted to compare data received from the memory addresses with said data pattern to generate said error signal.

7. A computer system according to claim 6, characterized in that said testing circuit includes an error storage register adapted in response to the provision of said error signal to store the address of a memory location providing erroneous data.
